# EUROPEAN PATENT APPLICATION

(11) **EP 4 668 533 A1**
(43) Date of publication of application: **24.12.2025**
(21) Application number: 24203210.0
(22) Date of filing: 27.09.2024
(51) Int. Cl.: H02J 7/00, B60L 3/00, B60L 58/10

(54) **ACCESS METHOD OF PARALLEL BRANCH IN BATTERY SYSTEM, BATTERY MANAGEMENT SYSTEM, DEVICE, AND STORAGE MEDIUM**

(30) Priority: 20.06.2024 US 202418748131
(71) Applicant: Microvast, Inc., Stafford, TX 77477 (US); Microvast GmbH, 14974 Ludwigsfelde (DE)
(72) Inventor: HUANG, Ying, 14974 Ludwigsfelde (DE); XIAO, Rui, Stafford, Texas, 77477 (US); Strommenger, Daniel, 14974 Ludwigsfelde (DE)
(74) Representative: Meyer-Dulheuer MD Legal Patentanwälte PartG mbB

(57) **Abstract**

An access method of a parallel branch in a battery system, a battery management system, a device, and a storage medium are provided. The method includes: detecting a to-be-accessed branch of a battery (S110), when the detection succeeds, acquiring a voltage difference between an accessed branch of a battery system and the to-be-accessed branch, and when the voltage difference satisfies a first preset range, accessing the to-be-accessed branch to the battery system (S120).

## Description

### TECHNICAL FIELD

The present invention generally relates to the field of battery management technology, and in particular, to an access method of a parallel branch in a battery system, a battery management system, a device, and a storage medium.

### BACKGROUND

During operation of a vehicle battery system, a BMS (Battery Management System) would disconnect a faulty branch and enter a limp mode in the event of certain faults (e.g., a severe overcurrent or a cell overvoltage). After the faults are corrected, a disconnected branch needs to be accessed to improve the operating performance of the vehicle battery system, e.g. to increase the power and mileage of the vehicle battery system.

Alternatively, after a battery pack is replaced in the vehicle battery system, there is a voltage difference between branches such that one or more branches cannot be accessed when starting to power on, i.e., the one or more branches are in a disconnected state. When a vehicle is in a driving mode, the one or more branches of the vehicle battery system in the disconnected state need to be accessed again.

For the issue of how to accurately and safely access the disconnected branch of a battery in the related art, no effective solution is proposed.

### SUMMARY

According to various embodiments of the present invention, an access method of a parallel branch in a battery system, a battery management system, a device, and a storage medium are provided.

In a first aspect, an access method of a parallel branch in a battery system is provided, including: detecting a to-be-accessed branch of a battery, when the detection succeeds, acquiring a voltage difference between an accessed branch of the battery system and the to-be-accessed branch, and when the voltage difference satisfies a first preset range, accessing the to-be-accessed branch to the battery system.

When the voltage difference satisfies the first preset range, it represents that no current impact exists between the to-be-accessed branch and the accessed branch of the battery system.

In some embodiments, conditions for the detection to succeed include: data of the to-be-accessed branch is in a readable state, the to-be-accessed branch is not in an alarm or error state, and a maximum branch current value of the accessed branch of the battery system is less than or equal to a first preset value.

The alarm or error state represents that the to-be-accessed branch is faulty. When the maximum branch current value of the accessed branch of the battery system is less than or equal to the first preset value, it represents that the current value of the accessed branch of the battery system will not interfere with determination of the voltage difference, and the to-be-accessed branch can be accessed to the battery system by further reducing the current value of the accessed branch of the battery system.

In some embodiments, before acquiring the voltage difference between the accessed branch of the battery system and the to-be-accessed branch, the method further includes: changing a system current request and a connection status signal. The connection status signal represents a connection status between the to-be-accessed branch and the accessed branch of the battery system.

The system current request represents an upper limiting value of the current of the accessed branch of the battery system in a process of accessing the to-be-accessed branch.

In some embodiments, changing the system current request and the connection status signal further includes: defining the system current request as: a second preset value * the quantity of the accessed branch of the battery system. When the voltage difference satisfies the first preset range, accessing the to-be-accessed branch to the battery system further includes: when the voltage difference satisfies the first preset range, a current value of the accessed branch of the battery system satisfies a second preset range, and a duration period satisfying foregoing two conditions is greater than or equal to a first preset time, accessing the to-be-accessed branch to the battery system.

The second preset value represents that when less than the upper limiting value of the battery system, the current of the accessed branch of the battery system does not impair a life of a relay of the battery. When the voltage difference satisfies the first preset range, and the current value of the accessed branch of the battery system satisfies the second preset range, it represents that no current impact exists between the to-be-accessed branch and the accessed branch of the battery system. The first preset time is configured to ensure that the current and a voltage of the accessed branch of the battery system are stable, and no power hopping situation will generate.

In some embodiments, changing the system current request and the connection status signal further includes: acquiring an initial voltage difference between the accessed branch of the battery system and the to-be-accessed branch, and an initial current value of the accessed branch of the battery system, and when the initial voltage difference and the initial current value satisfy a preset condition, performing the step of changing the system current request and the connection status signal.

In some embodiments, the method further includes: when the battery has a plurality of to-be-accessed branches which are at a same voltage level, accessing the plurality of to-be-accessed branches to the battery system simultaneously.

In some embodiments, the method further includes: within a second preset time, when the voltage difference does not satisfy the first preset range, the current value of the accessed branch of the battery system does not satisfy the second preset range, or a duration period satisfying either of the foregoing two conditions is shorter than the first preset time, returning to the step of acquiring the initial voltage difference between the accessed branch of the battery system and the to-be-accessed branch, and the initial current value of the accessed branch of the battery system.

In some embodiments, the method further includes: after accessing the to-be-accessed branch to the battery system, updating a limiting current of the battery system according to the quantity of accessed branches.

In some embodiments, conditions for the detection to succeed include: data of the to-be-accessed branch is in a readable state, and the to-be-accessed branch is not in an alarm or error state.

The alarm or error state represents that the to-be-accessed branch is faulty.

In some embodiments, when the voltage difference satisfies the first preset range, accessing the to-be-accessed branch to the battery system further includes: acquiring an average current value of accessed branches according to an actual operating current of the battery and the quantity of the accessed branches, and when the voltage difference satisfies the first preset range, the average current value satisfies a second preset range, and a duration period satisfying foregoing two conditions is in a third preset time range, accessing the to-be-accessed branch to the battery system.

In some embodiments, accessing the to-be-accessed branch to the battery system further includes: after the voltage difference satisfies the first preset range, the average current value satisfies the second preset range, and the duration period satisfying foregoing two conditions is in the third preset time range, when a duration period in which the average current value satisfies a third preset range reaches a fourth preset time, accessing the to-be-accessed branch to the battery system in a fifth preset time.

In some embodiments, the method further includes: when the duration period in which the average current value satisfies a third preset range does not reach a fourth preset time, aborting the step of accessing the to-be-accessed branch to the battery system, and returning to the step of acquiring the voltage difference between the accessed branch of the battery system and the to-be-accessed branch.

In a second aspect, a battery management system is further provided, which is configured to execute the method in the first aspect.

In a third aspect, an electronic device is further provided, including a memory, a processor, and a computer program stored on the memory and capable of operating on the processor. The processor is configured to execute the computer program to perform the method in the first aspect.

In a fourth aspect, a storage medium is further provided. The storage medium stores a computer program. The computer program is executed by a processor to perform the method in the first aspect.

Details of one or more embodiments of the present invention are provided in the following accompanying drawings and descriptions. Other features, objects, and advantages of the present invention will become apparent from the description, the accompanying drawings, and the claims.

### BRIEF DESCRIPTION OF THE DRAWINGS

In order to more clearly illustrate the technical solutions in the embodiments of the present invention or in the related technology, the accompanying drawings to be used in the description of the embodiments or the related technology will be briefly introduced below, and it is obvious that the accompanying drawings in the following description are only some of the embodiments of the present invention, and that, for one skilled in the art, other accompanying drawings can be obtained based on these accompanying drawings without putting in creative labor.
FIG. 1 is a flowchart of an access method of a parallel branch in a battery system in an embodiment.
FIG. 2 is a partial flowchart of an access method of a parallel branch in a battery system in an embodiment.
FIG. 3 is a partial flowchart of an access method of a parallel branch in a battery system in an embodiment.
FIG. 4 is a schematic diagram of a connection of a battery management system in an embodiment.
FIG. 5 is an internal structural diagram of a computer device in an embodiment.
FIG. 6 is a schematic diagram of an electronic device in an embodiment.

### DETAILED DESCRIPTION OF THE EMBODIMENT

The technical solutions in the embodiments of the present invention will be described clearly and completely in the following in conjunction with the accompanying drawings in the embodiments of the present invention, and it is obvious that the described embodiments are only a part of the embodiments of the present invention, but not all of the embodiments. Based on the embodiments in the present invention, all other embodiments obtained by one skilled in the art without making creative labor fall within the scope of protection of the present invention.

Unless otherwise defined, technical terms or scientific terms involved in the present invention have the same meanings as would generally understood by one skilled in the technical field of the present invention. In the present invention, "a", "an", "one", "the", and other similar words do not indicate a quantitative limitation, which may be singular or plural. The terms such as "comprise", "include", "have", and any variants thereof involved in the present invention are intended to cover a non-exclusive inclusion. For example, processes, methods, systems, products, or devices including a series of steps or modules (units) are not limited to these steps or modules (units) listed, and may include other steps or modules (units) not listed, or may include other steps or modules (units) inherent to these processes, methods, systems, products, or devices. Words such as "join", "connect", "couple", and the like involved in the present invention are not limited to physical or mechanical connections, and may include electrical connections, whether direct or indirect. "A plurality of" involved in the present invention means two or more. The term "and/or" describes an association relationship between associated objects and represents that three relationships may exist. For example, "A and/or B" may represent the following three cases: only A exists, both A and B exist, and only B exists. In general, a symbol "/" may indicate that objects before and after "/" are associated in an "or" relationship. The terms "first", "second", "third", and the like involved in the present invention are only intended to distinguish similar objects and do not represent specific ordering of the obj ects.

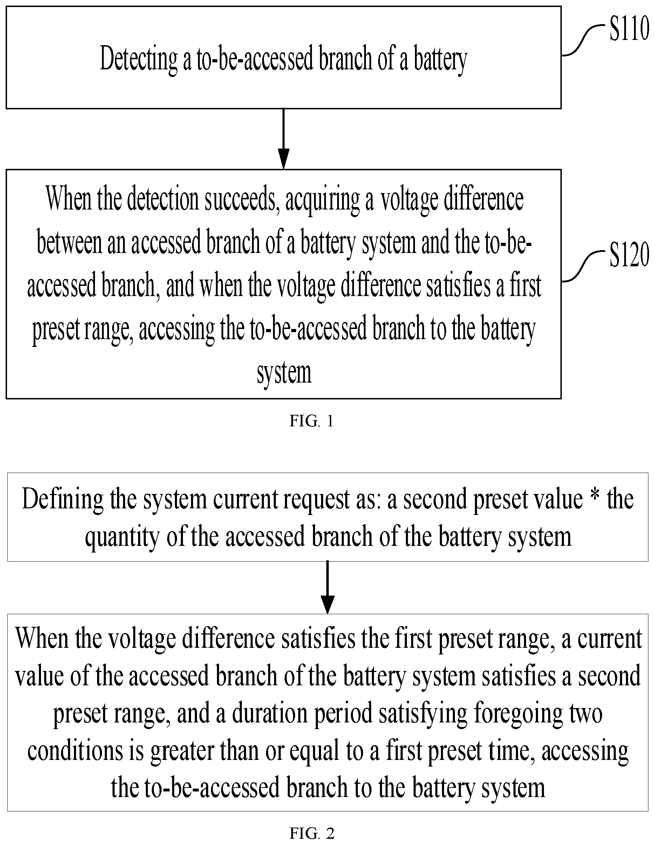

An access method of a parallel branch in a battery system is provided in an embodiment of the present invention. FIG. 1 is a flowchart of an access method of a parallel branch in a battery system in an embodiment. Referring to FIG. 1, the method includes step 110 and step 120.

Step 110 includes detecting a to-be-accessed branch of a battery.

At the step 110, the battery may be a battery in a vehicle battery system, or a battery apparatus in other power-consuming devices. The battery may have a plurality of parallel branches generally. Each branch may include a single battery pack or a plurality of battery packs in series/parallel, so as to provide a stable voltage and current, and ensure sufficient battery power. The battery in the vehicle battery system may be used as an example. In an operating process, a battery management system may disconnect a faulty branch in the event of certain faults (e.g., a severe overcurrent or a cell overvoltage). After the faults are corrected, a disconnected branch needs to be accessed to improve the operating performance of the vehicle battery system, e.g. to increase the power and mileage of the vehicle battery system. Alternatively, after a battery pack is replaced in the vehicle battery system, there is a voltage difference between branches such that one or more branches cannot be accessed when starting to power on, i.e., the one or more branches may be in a disconnected state. When a vehicle is in a driving mode, the one or more branches of the vehicle battery system in the disconnected state need to be accessed again. The one or more branches that need to be accessed may be the to-be-accessed branch of the battery, and a branch that is already operating normally in the vehicle battery system may be an accessed branch of the battery system. To access the branch of the battery in a disconnected state accurately, before an access operation, the to-be-accessed branch needs to be detected, so as to satisfy access conditions of the branch.

Step 120 includes that when the detection succeeds, acquiring a voltage difference between an accessed branch of a battery system and the to-be-accessed branch, and when the voltage difference satisfies a first preset range, accessing the to-be-accessed branch to the battery system.

When the voltage difference satisfies the first preset range, it represents that no current impact exists between the to-be-accessed branch and the accessed branch of the battery system.

At the step 120, when the detection of the to-be-accessed branch succeeds, a voltage value of the accessed branch of the battery system and a voltage value of the to-be-accessed branch may be acquired and compared to obtain the voltage difference, and it may be determined whether the voltage difference is in the first preset range. When the voltage difference is in the first preset range, it represents that no current impact exists between the to-be-accessed branch and the accessed branch of the battery system, and the to-be-accessed branch may be accessed to the battery system. The first preset range may be adjusted according to a battery specification, which is not limited herein.

In the present embodiment, in a use process of the battery, a corresponding branch cannot continue to be used because of various faults or a battery pack replacement. When the detection succeeds, a disconnected branch of the battery may be accessed to the battery system by the above processes, thereby effectively avoiding a risk of relay damage caused by the current impact that may occur when the branch is forcibly accessed, saving time for the power-consuming devices to be shut down for maintenance and updates, and ensuring safe and stable operation of the battery.

In some embodiments, conditions for the detection to succeed may include: data of the to-be-accessed branch is in a readable state, the to-be-accessed branch is not in an alarm or error state, and a maximum branch current value of the accessed branch of the battery system is less than or equal to a first preset value. A branch current value means a current value of the branch, and a maximum branch current value of the accessed branch means a current value of the branch that has the maximum current value comparing with any other current value of the accessed branch of the battery system or any other current value of other accessed branches of the battery system.

The alarm or error state may represent that the to-be-accessed branch is faulty. When the maximum branch current value of the accessed branch of the battery system is less than or equal to the first preset value, it represents that the current value of the accessed branch of the battery system will not interfere with determination of the voltage difference, and the to-be-accessed branch can be accessed to the battery system by further reducing the current value of the accessed branch of the battery system.

In the present embodiments, to ensure smooth access to the battery system and stable and reliable operation of the disconnected branch, the to-be-accessed branch may be detected and the conditions for the detection to succeed may be set. When the data of the to-be-accessed branch is in a readable state, it may be determined that the to-be-accessed branch can be controlled and accessed to the battery system. When the to-be-accessed branch is not in the alarm or error state, it may ensure that the to-be-accessed branch is not faulty, and avoid access failure and damage to the battery. The maximum branch current value of the accessed branch of the battery system is less than or equal to the first preset value, so as to avoid excessive current impact after the to-be-accessed is accessed and damaging a relay or other high voltage components.

Furthermore, the data of the to-be-accessed branch may include data of Controller Area Network to which the to-be-accessed branch belongs or other kinds of control data.

Furthermore, the alarm or error status of the to-be-accessed branch may be determined based on a 5-level alarm system. Exemplarily, alarm levels 1 to 5 may be extremely low, low, medium, high, and extremely high, respectively. During detection, when an alarm level of the to-be-accessed branch is greater than level 2, it may indicate that the to-be-accessed branch is in the alarm or error state. When the alarm level of the to-be-accessed branch is level 1 or level 2, it may indicate that the to-be-accessed branch is not in the alarm or error state. The maximum branch current value of the accessed branch of the battery system may be acquired by real-time monitoring and comparison. The maximum branch current value of the accessed branch of the battery system may refer to an absolute value of a current. The first preset value may be determined according to the battery specification, such as, 10A, 15A, 20A, 25A, 30A, or the like. The first preset value may be less than 10% of a peak current of the battery, which is not limited in the present invention. The maximum branch current value of the accessed branch of the battery system may be limited to ensure a small voltage error.

In some embodiments, before acquiring the voltage difference between the accessed branch of the battery system and the to-be-accessed branch, the method may further include: changing a system current request and a connection status signal. The connection status signal may represent a connection status between the to-be-accessed branch and the accessed branch of the battery system.

The system current request may represent an upper limiting value of the current of the accessed branch of the battery system in a process of accessing the to-be-accessed branch.

In the present embodiments, before the voltage difference between the accessed branch of the battery system and the to-be-accessed branch is acquired, the system current request and the connection status signal may be changed to ensure that the to-be-accessed branch can be accessed accurately, safely, and stably. The system current request may be changed to stabilize the system current, so that the current does not change too much, and the connection status signal may be changed to accurately monitor the connection status between the to-be-accessed branch and the accessed branch of the battery system.

Specifically, the vehicle battery system may be used as an example. Before the battery management system acquires the voltage difference between the accessed branch of the battery system and the to-be-accessed branch, the battery management system may send the system current request and the connection status signal to a Vehicle Control Unit (VCU). When receiving true feedback from the Vehicle Control Unit, the battery management system may access the to-be-accessed branch to the battery system according to an actual current of the battery system and the connection status signal. It should be noted that before and after the to-be-accessed branch is accessed to the battery system, the connection status signal may change.

Furthermore, a connection status represented by the connection status signal may include no action, waiting, connecting in progress, connecting completion, error, or the like. The system current request may be valid when the connection status signal represents waiting or connecting in progress.

In some embodiments, referring to FIG. 2, changing the system current request and the connection status signal may further include: defining the system current request as: a second preset value * the quantity of the accessed branch of the battery system. When the voltage difference satisfies the first preset range, accessing the to-be-accessed branch to the battery system may further include: when the voltage difference satisfies the first preset range, a current value of the accessed branch of the battery system satisfies a second preset range, and a duration period satisfying foregoing two conditions is greater than or equal to a first preset time, accessing the to-be-accessed branch to the battery system.

The second preset value may represent that when less than the upper limiting value of the current of the accessed branch of the battery system, the current of the accessed branch of the battery system does not impair a life of the relay of the battery. When the voltage difference satisfies the first preset range, and the current value of the accessed branch of the battery system satisfies the second preset range, it represents that no current impact exists between the to-be-accessed branch and the accessed branch of the battery system. The first preset time is configured to ensure that the current and the voltage of the accessed branch of the battery system are stable, and no power hopping situation will generate.

In the present embodiments, the system current request may be defined as: the second preset value * the quantity of the accessed branch of the battery system, so as to limit an overall current of the battery system, thereby limiting the current of the accessed branch of the battery system. Before accessing the to-be-accessed branch to the battery system, the voltage difference, the current value of the accessed branch of the battery system, and the duration period may be limited to ensure that the current of the accessed branch of the battery system is stable.

It should be noted that, the meaning of the current value of the accessed branch of the battery system satisfying the second preset range is that current values of all accessed branches of the battery system satisfy the second preset range.

Furthermore, the first preset range and the second preset range may be determined according to the battery specification, the second preset value may be determined according to the relay of the battery and a current requirement, and the first preset time may be adjusted according to an actual use status of the battery, which are not limited in the present invention.

The vehicle battery system may be used as an example. Because the system current request is defined as: the second preset value * the quantity of the accessed branch of the battery system, the battery management system may limit a total current of the battery system to be less than the upper limiting value of the current, and accessing process of the to-be-accessed branch may generally not cause change of the total current of the battery system, but change of a current allocation between branches. When it is confirmed that the voltage difference satisfies the first preset range, the current value of the accessed branch of the battery system satisfies the second preset range, and the duration period satisfying foregoing two conditions is greater than or equal to the first preset time, the battery management system may access the to-be-accessed branch to the battery system. In this way, the current may not cause damage to high-voltage components (such as the relay) of the vehicle, while still ensuring that the vehicle is supplied with current for safety purposes, such as power steering and braking system operation.

Specifically, the first preset range may be -4V to 0V, the second preset range may be 0A to 10A, the first preset time may be 15s, 18s, 20s, 22s, 25s, or the like. Alternatively, the first preset range may be 0V to 4V, the second preset range may be -10A to 0A, the first preset time may be 15s, 18s, 20s, 22s, 25s, or the like. The second preset value may be 8A, 9A, 10A, 11A, 12A, or the like.

Furthermore, the method may further include: acquiring an initial voltage difference between the accessed branch of the battery system and the to-be-accessed branch, and an initial current value of the accessed branch of the battery system, and when the initial voltage difference and the initial current value satisfy a preset condition, performing the step of changing the system current request and the connection status signal.

In the present embodiments, before performing the step of changing the system current request and the connection status signal, the initial voltage difference between the accessed branch of the battery system and the to-be-accessed branch may be acquired, and the initial current value of the accessed branch of the battery system may be acquired. It may be determined whether the initial voltage difference and the initial current value satisfy a preset condition, if yes, the step of changing the system current request and the connection status signal may be performed.

It should be noted that the preset condition may be determined comprehensively according to whether the voltage and the current of the accessed branch of the battery system and the to-be-connected branch are proximal to each other as well as an actual requirement. The initial voltage difference and the initial current value may be measured and acquired directly after the to-be-accessed branch of the battery is successfully detected. When it is determined whether the voltage difference satisfies the first preset range and the current value of the accessed branch of the battery system satisfies the second preset range, the voltage difference and the current value may be measured and acquired after changing the system current request and the connection status signal.

Specifically, the preset condition may be:
the initial voltage difference is in a range of -12V to -8V, and the initial current value of the accessed branch of the battery system is in a range of 20A to 30A,
the initial voltage difference is in a range of -8V to -4V, and the initial current value of the accessed branch of the battery system is in a range of 10A to 20A,
the initial voltage difference is in a range of -4V to 0V, and the initial current value of the accessed branch of the battery system is in a range of 0A to 10A,
the initial voltage difference is in a range of 0V to 4V, and the initial current value of the accessed branch of the battery system is in a range of -10A to 0A,
the initial voltage difference is in a range of 4V to 8V, and the initial current value of the accessed branch of the battery system is in a range of -20A to -10A, or
the initial voltage difference is in a range of 8V to 12V, and the initial current value of the accessed branch of the battery system is in a range of -30A to -20A.

When the initial voltage difference and the initial current value of the accessed branch of the battery system satisfy any of the above ranges, the step of changing the system current request and the connection status signal may be performed. The to-be-accessed branch may have no current, the measured voltage of the to-be-accessed branch is an open-circuit voltage. However, there is current in the accessed branch of the battery system, and the measured voltage of the accessed branch of the battery system is different from an actual open-circuit voltage of the accessed branch of the battery system. At the time of accessing, the same or similar open-circuit voltage of the two branches can avoid current impact due to the voltage difference. Therefore, a voltage difference range and a current range need to be added to the preset condition simultaneously. After it is determined that the initial voltage difference and the initial current value of the accessed branch of the battery system are within the foregoing ranges, it is confirmed that a branch access may be performed. After the system current request and the connection status signal are changed, the voltage difference may be limited by the first preset range, the current value of the accessed branch of the battery system may be limited by the second preset range, and the duration period may be limited by the first preset time, so as to ensure that the battery system is in a stage of a low power requirement during which a sudden power jump requirement may generally not exist. A continuous small current may thus reduce impact of dynamic operation of the battery, so that voltage measurement may be relatively accurate, the voltage difference may be relatively accurate, and impact in an access process may be avoided.

In some embodiments, the method may further include: when the battery has a plurality of to-be-accessed branches which are at a same voltage level, accessing the plurality of to-be-accessed branches to the battery system simultaneously.

In the present embodiments, when the battery has a plurality of to-be-accessed branches which are at the same voltage level, the plurality of to-be-accessed branches may be accessed to the battery system simultaneously, so as to save access time.

Furthermore, when the voltage difference satisfies the first preset range, the current value of the accessed branch of the battery system satisfies the second preset range, the duration period satisfying foregoing two conditions is greater than or equal to the first preset time, and the battery has the plurality of to-be-accessed branches which are at the same voltage level, the plurality of to-be-accessed branches may be accessed to the battery system simultaneously, so as to save access time.

Furthermore, when the battery has a plurality of to-be-accessed branches which are at different voltage levels, to-be-accessed branches which are at the same voltage level may be accessed to the battery system, and the other to-be-accessed branches which are at different voltage levels may be re-determined whether to be accessed to the battery system by the access method of the parallel branch in the battery system, so as to avoid a large fluctuation of the voltage and the current caused by the to-be-accessed branches accessed to the battery system simultaneously which are at different voltage levels.

Specifically, the voltage level may include a voltage difference. Exemplarily, the voltage level of the to-be-accessed branch may be represented by the voltage difference relative to the battery system. When there are three to-be-accessed branches, two of which have a voltage difference relative to the battery system in a range of -4V to 0V, and the other to-be-accessed branch has a voltage difference relative to the battery system in a range of 0V to 4V, then the two to-be-accessed branches may be at the same voltage level (the voltage difference is in the range of -4V to 0V), and the other to-be-accessed branch may be at a different voltage level (the voltage difference is in the range of 0V to 4V). The two to-be-accessed branches may be accessed to the battery system at the same time, and the other to-be-accessed branch may be re-determined whether to be accessed to the battery system by the access method of the parallel branch in the battery system.

In addition, when the to-be-accessed branch is accessed to the battery system, the connection status signal may represent connecting in progress. The battery management system may send the system current request to the Vehicle Control Unit, the system current request may include the second preset value, and the Vehicle Control Unit may perform current limitation according to the second preset value, so as to ensure stable operation.

In some embodiments, the method may further include: within a second preset time, when the voltage difference does not satisfy the first preset range, the current value of the accessed branch of the battery system does not satisfy the second preset range, or a duration period satisfying either of the foregoing two conditions is shorter than the first preset time, returning to the step of acquiring the initial voltage difference between the accessed branch of the battery system and the to-be-accessed branch, and the initial current value of the accessed branch of the battery system.

In the present embodiments, because the voltage and the current of the battery branch may change, the voltage difference, the current value of the accessed branch of the battery system, and the duration period may be monitored within the second preset time to see if they satisfy the conditions at the same time. When one of the conditions is not met, the step of acquiring the initial voltage difference between the accessed branch of the battery system and the to-be-accessed branch, and the initial current value of the accessed branch of the battery system may be performed again.

Specifically, the second preset time may be adjusted according to an actual requirement, such as 3 minutes, 4 minutes, or 5 minutes. When returning to the step of acquiring the initial voltage difference between the accessed branch of the battery system and the to-be-accessed branch, and the initial current value of the accessed branch of the battery system, the connection status signal may be set as no action.

In some embodiments, the method may further include: after accessing the to-be-accessed branch to the battery system, updating a limiting current of the battery system according to the quantity of accessed branches.

In the present embodiments, when the to-be-accessed branch is accessed to the battery system, a current limitation needs to be performed on the battery system. After the access is completed, a current limitation of the branch may be restored to a normal value, and the limiting current of the battery system may be updated according to the quantity of the accessed branches.

Furthermore, after the to-be-accessed branch is accessed to the battery system, the connection status signal may be set as no action. The normal value of the current limitation of the branch may be determined based on a SOC (state of charge) and a temperature value according to a current limitation table dedicated to the branch of the battery.

The above access method of the parallel branch in the battery system may be applied to the vehicle battery system. In a specific embodiment, the vehicle battery system may relate to a battery management system (BMS). The BMS may interact with the VCU. When the vehicle battery system in a driving state has a new branch access requirement, following steps may be performed: step one may include detecting a to-be-accessed branch to ensure that the to-be-accessed branch is not faulty and satisfies access conditions, and step two may include executing a check algorithm. MBMU (master battery management unit) may acquire the voltage difference between the to-be-accessed branch and the current system branch, and determine whether the to-be-accessed branch satisfies the access conditions. When it is determined that the access is allowed, the system current request and the connection status signal may be changed to gradually access the to-be-accessed branch.

When a battery system with a plurality of groups of parallel batteries is used and a group of parallel batteries cannot continue to be used due to various faults, the battery system may disconnect a branch corresponding to the group of parallel batteries temporarily. After the faults are corrected, the formerly disconnected branch may be accessed to the battery system in operating by the above control strategy, thereby effectively avoiding the risk of the relay damage due to excessive current when the branch is forcibly accessed, saving shutdown time for maintenance and updating during driving, and ensuring that the vehicle can run continuously, safely, and stably.

To ensure that the disconnected branch can be accessed to the battery system smoothly and a new system can operate stably and reliably, following process may be designed in the present invention:
1. Activating detection of the disconnected branch which is possibly accessed to the battery system, including following conditions (a, b, and c):
   a. CAN (Controller Area Network) data of the disconnected branch can be read and used for BMS control.
   b. No alarm/error is activated in the branch (level > 2, based on the 5-level alarm system).
   c. II_string 1<=30A (I_string is the maximum branch current value of the accessed branch), and a value of 30A is determined according to a battery pack specification, which is not limited in the present invention.
2. Executing the check algorithm.
   a. Measured voltage and current values of the accessed branch and the disconnected branch are sent to MBMU for comparison. The MBMU is a controller in the BMS, and the MBMU is configured to control the branch and be in communication with the vehicle. When a voltage difference (U_diff) between the accessed branch and the disconnected branch satisfies a preset condition, the BMS can start an access process.
      The preset condition is:
      (20A < I_string <= 30A) & (-12V < U_diff <= -8V),
      (10A < I_string <= 20A) & (-8V < U_diff <= -4V),
      (0A < I_string <= 10A) & (-4V < U_diff <= 0V),
      (-10A < I_string <= 0A) & (0V < U_diff <= 4V),
      (-20A < I_string <= -10A) & (4V < U_diff <= 8V), or
      (-30A < I_string <= -20A) & (8V < U_diff <= 12V).
   b. Once the preset condition at step a is satisfied, the BMS sends a system current request (I_req_BMS) and a connection status signal (BalConnectionSts) to the VCU, and the connection status signal represents a connection status between the accessed branch and the disconnected branch, which is determined by the voltage difference therebetween.
      i. BalConnectionSts=0, no action. BalConnectionSts=1, waiting. BalConnectionSts=2, connecting in progress. BalConnectionSts=3, connecting completion. BalConnectionSts=4, error.
      ii. I_req_BMS is valid when BalConnectionSts=1 or 2, otherwise, I_req_BMS can be ignored.
      iii. I_req_BMS = 10A * the quantity of the accessed branch. 10A is determined according to the battery pack specification. That is, when the disconnected branch is accessed under the current value, the current does not cause damage to a high voltage component (such as a relay). At the same time, it is still ensured that the vehicle is supplied with current for safety purposes, such as power steering and braking system operation.
   c. I_req_BMS is an expected current value of the BMS, which defines an upper limiting value of the current for starting the access process. The VCU can determine, according to an actual driving condition, whether to comply with the system current request.
   d. The BMS waits for feedback from the VCU (BalConnectionCmd_VCU) to see whether the access can be started.
      i. When the feedback is false, the BMS exits the access process. The feedback of the VCU means that the vehicle determines whether the disconnected branch can be accessed. In some cases, the vehicle determines a system current to be increased after the access. When the access operation cannot be performed, the VCU gives a rejection (i.e., false) feedback, and the BMS gives up the access operation.
      ii. When the feedback is true, the BMS starts the access process:
         - The BMS sets a real-time limiting current to 10A / branch and sends the connection status signal (BalConnectionSts=2) to the VCU to notify the start of the access.
         - The BMS monitors the current and voltage of the branch continuously. When following conditions are satisfied, the BMS starts the access operation:
            (0A < I_string <= 10A) & (-4V < U_diff <= 0V) & (duration > 20s), or
            (-10A < I_string <= 0A) & (0V < U_diff<= 4V) & (duration > 20s).
         - When more branches have the same voltage level, these branches will be accessed at the same time.
         - Limiting time of this process is 5 minutes. When the above conditions are not met within 5 minutes, the BMS will set the connection status signal (BalConnectionSts=0) and return to step a of executing the check algorithm.
         - It should be noted that, when BalConnectionSts=2, the VCU must be in a stable operation (following the reduced limiting current) to enable the access process, otherwise, a sudden increase in current will cause damage to the relay. The BMS sets the real-time limiting current to 10A / branch, and then sends a limiting system current to the VCU according to the quantity of the accessed branch. The VCU needs to limit the current as required by the BMS.
   e. Once the access process is successfully completed, the BMS will:
      i. Set the connection status signal (BalConnectionSts=3).
      ii. Set the system current request (I_req_BMS=N/A), and N/A represents not available.
      iii. Update limiting current of the battery system according to the quantity of accessed branch.
      iv. Change the connection status signal (BalConnectionSts=0) after 30 seconds.
   f. When more disconnected branches exist and the conditions at step one are satisfied, the BMS will repeat step a to step e to access all disconnected branches.

In the above specific embodiment, the BMS may interact with the VCU to determine the access process. In other embodiments, the access method of the parallel branch in the battery system may be performed by the BMS.

In some embodiments, the access method of the parallel branch in the battery system includes: detecting the to-be-accessed branch of the battery, when the detection succeeds, acquiring the voltage difference between the accessed branch of the battery system and the to-be-accessed branch, and when the voltage difference satisfies the first preset range, accessing the to-be-accessed branch to the battery system. Conditions for the detection to succeed may include: data of the to-be-accessed branch is in a readable state, and the to-be-accessed branch is not in an alarm or error state.

In the present embodiment, to ensure smooth access to the battery system and stable and reliable operation of the disconnected branch, the to-be-accessed branch may be detected and the conditions for the detection to succeed may be set. When the data of the to-be-accessed branch is in a readable state, it may be determined that the to-be-accessed branch can be controlled and accessed to the battery system. When the to-be-accessed branch is not in the alarm or error state, it may ensure that the to-be-accessed branch is not faulty, avoiding access failure and damage to the battery.

Furthermore, the data of the to-be-accessed branch may include data of Controller Area Network to which the to-be-accessed branch belongs or other kinds of control data.

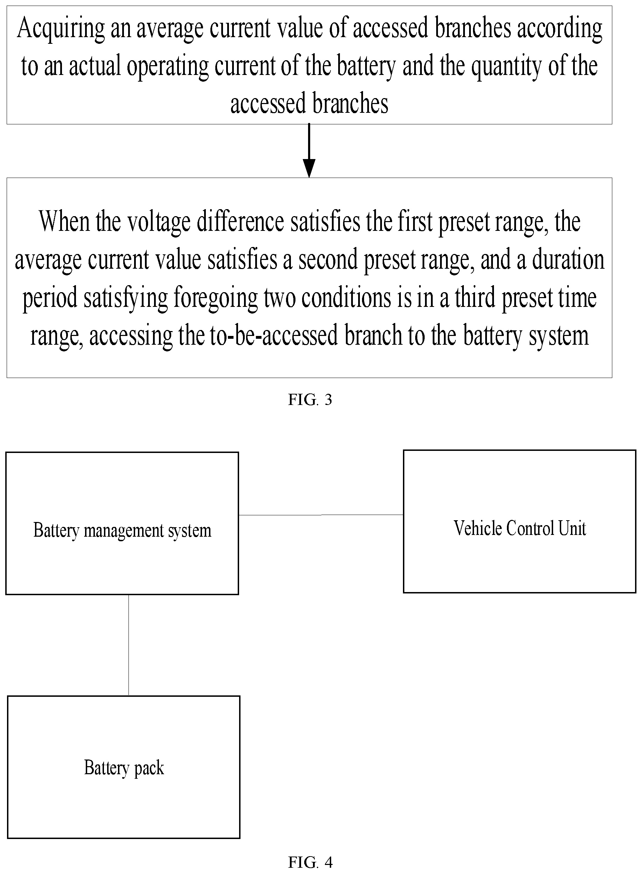

In some embodiments, referring to FIG. 3, when the voltage difference satisfies the first preset range, accessing the to-be-accessed branch to the battery system may further include:

Acquiring an average current value of accessed branches according to an actual operating current of the battery and the quantity of the accessed branches.

When the voltage difference satisfies the first preset range, the average current value satisfies a second preset range, and a duration period satisfying foregoing two conditions is in a third preset time range, accessing the to-be-accessed branch to the battery system.

In the present embodiments, unlike limiting the current value of each branch of the battery system, the average current value of the accessed branches of the battery system is limited. Even if current values of some branches are large, it may ensure that an overall current of the battery is stable.

Specifically, the first preset range may be in a range of -4V to 0V, the second preset range may be in a range of 0A to 10A, and the third preset time range may be in a range of 10s to 12s. Alternatively, the first preset range may be in a range of 0V to 4V, the second preset range may be in a range of -10A to 0A, and the third preset time range may be in a range of 10s to 12s.

The third preset time range may be in a range of 5s to 8s, 8s to 10s, 12s to 15s, or the like, which is not limited in the present invention.

It should be noted that a discharging current of the battery may be a positive value, and a charging current of the battery may be a negative value. When the battery is discharging, the discharging current may pull down the voltage of the accessed branches. When the battery is charging, the charging current may pull up the voltage of the accessed branch, and the voltage difference may be a difference between the voltage of the accessed branch and the voltage of the to-be-accessed branch.

In some embodiments, accessing the to-be-accessed branch to the battery system may further include: after the voltage difference satisfies the first preset range, the average current value satisfies the second preset range, and the duration period satisfying foregoing two conditions is in the third preset time range, when a duration period in which the average current value satisfies a third preset range reaches a fourth preset time, accessing the to-be-accessed branch to the battery system in a fifth preset time.

In the present embodiments, before the to-be-accessed branch is accessed to the battery system, the average current and duration period thereof may be further limited, and access time of the to-be-accessed branch may also be limited, so as to ensure that the to-be-accessed branch can be accessed to the battery system quickly and stably.

Specifically, the fourth preset time may be set to 1s, 2s, 3s, or the like, and the fifth preset time may be set to 250ms, 300ms, 350ms, or the like. It should be noted that the third preset time range is configured to compare with the duration period in which the voltage difference satisfies the first preset range, and the duration period in which the average current value satisfies the second preset range, before accessing the to-be-accessed branch. In other words, the third preset time range is configured to determine whether to access the to-be-accessed branch. The fourth preset time is configured to compare with the duration period in which the average current value satisfies a third preset range before accessing the to-be-accessed branch. In other words, the fourth preset time is used after the to-be-accessed branch is determined to be accessed.

In addition, the third preset range corresponding to the average current value may be same as the second preset range. However, the second preset range is for a system current in actual operation, and the third preset range is for a limiting current of the battery system.

In some embodiments, the method may further include: when the duration period in which the average current value satisfies the third preset range does not reach the fourth preset time, aborting the step of accessing the to-be-accessed branch to the battery system, and returning to the step of acquiring the voltage difference between the accessed branch of the battery system and the to-be-accessed branch.

In the present embodiments, before the to-be-accessed branch is accessed to the battery system, it is possible that the duration period in which the average current value satisfies the third preset range does not reach the fourth preset time range. In this case, damage may be caused to the battery system, the step of accessing the to-be-accessed branch to the battery system may be aborted, and the voltage difference between the accessed branch of the battery system and the to-be-accessed branch may be acquired again. It should be noted that the foregoing determining process is before the step of accessing the to-be-accessed branch to the battery system.

The foregoing access method of the parallel branch in the battery system may be applied to the vehicle battery system. In a specific embodiment, the vehicle battery system may relate to the BMS. When the vehicle battery system in the driving state has a new branch access requirement, following steps may be performed:
1. Activating detection of the disconnected branch which is possibly accessed to the battery system, including following conditions (a and b):
   a. CAN (Controller Area Network) data of the disconnected branch can be read and used for BMS control.
   b. No alarm/error is activated in the branch (level > 2, based on the 5-level alarm system).
2. Executing a check algorithm.
   a. Measured voltage and current values of the accessed branches and the disconnected branch are sent to MBMU for comparison. When a voltage difference (U_diff) between the accessed branch and the disconnected branch and an actual system current (an actual operating current of the battery system) satisfy following conditions, the BMS can start an access process: (0A < I_system/number of connected strings <= 10A) & (-4V < U_diff <= 0V), or (-10A < I_system/number of connected strings <= 0A) & (0V < U_diff <= 4V).
   b. Starting the access process.
      (This control strategy is implemented passively, i.e., the BMS may monitor an operating status of the vehicle, and when it is determined that a disconnected group of parallel batteries can be accessed, corresponding group of parallel batteries can be accessed quickly. This control may avoid a complex BMS-VCU interaction process and may be controlled by the BMS independently, and does not affect normal operation of the vehicle. A chance of accessing the disconnected branch may be missed because the condition is not satisfied, but access may be performed when the condition is satisfied again. )
      i. Once the preset condition at step a is satisfied and maintained for 10 seconds, the BMS will set Max_Discharge_current/Max_regenerate_current = Max (10A * number of connected strings). Max_Discharge_current represents a maximum allowable discharging current, Max_regenerate_current represents a maximum allowable feedback current, and a ratio of the maximum allowable discharging current to the maximum allowable feedback current represents a maximum allowable branch current.
         The maintaining time 10s need to be determined according to a use requirement and cell performance. When the maintaining time is too long, it is difficult to satisfy a determination condition. When the maintaining time is too short, since the voltage of a battery cell varies dynamically at a high current, the voltage measured by the BMS may be inaccurate (which is quite different from an actual OCV (Open Circuit Voltage)). According to test data of the battery cell, a percentage of the voltage relative to the OCV measured at different time points after the current of the battery cell drops from the high current was calculated, so as to determine the maintaining time. From the test data, a time range from 10s to 20s may satisfy the requirement. The maintaining time 10s may ensure that no sudden power jump occurs when the vehicle is in a low power consumption phase, and may ensure that the battery system can have a stable time, which may also improve impact of a subsequent access process.
         The foregoing solution related to the VCU may have a longer determining time compared to the present solution, and have a BMS-VCU interaction. In other words, the vehicle may know and agree to the access operation, and the determining time is longer. In this case, the voltage measured by the BMS is relatively accurate to ensure security of the access process.
         The present solution may be implemented passively by the BMS. When the determining time is too long, it may be difficult to satisfy a determining condition. Therefore, the present solution shortens the determining time while measurement accuracy may be ensured. A test on an actual vehicle has verified that the determining time is feasible.
      ii. After the system current is limited in a range within 2s, the BMS may send a power-on command to the disconnected branch. The access process will be completed within 300ms. Before the access process, to avoid a sharp change of the system current during the access process, the BMS may limit the current for 2s, and the maximum system current may be Max_Discharge_current/Max_regenerate_current = Max (10A * number of connected strings). The foregoing maintaining time 10s is configured to determine that the battery system is in a relatively stable low-power state. In this case, the current is actively limited for 2s, so that the disconnected branch may be accessed safely, so as to avoid a sudden current increase in the access process.
         After the disconnected branch is accessed, the additional limiting current may be removed, restoring to a normal limiting current of the battery system. The normal limiting current value may be calculated according to a limiting current value of the battery pack, which is related to the SOC and the temperature, i.e., I_system = min (I_pack1, I_pack2, 1_pack3, ... , I_packx) * the quantity of accessed branches.
      iii. When the system current exceeds the limiting current in 2s, the BMS will abort the access process and return to the step a of executing the check algorithm.

It should be noted that the steps shown in the above process or in the flowchart of the accompanying drawings may be performed in a computer system such as a set of computer executable instructions. Although a logical sequence is shown in the flowchart, in some cases the steps shown or described may be performed in a different sequence.

Referring to FIG. 4, a battery management system is further provided in the present invention, which is configured to execute the access method of the parallel branch in the battery system.

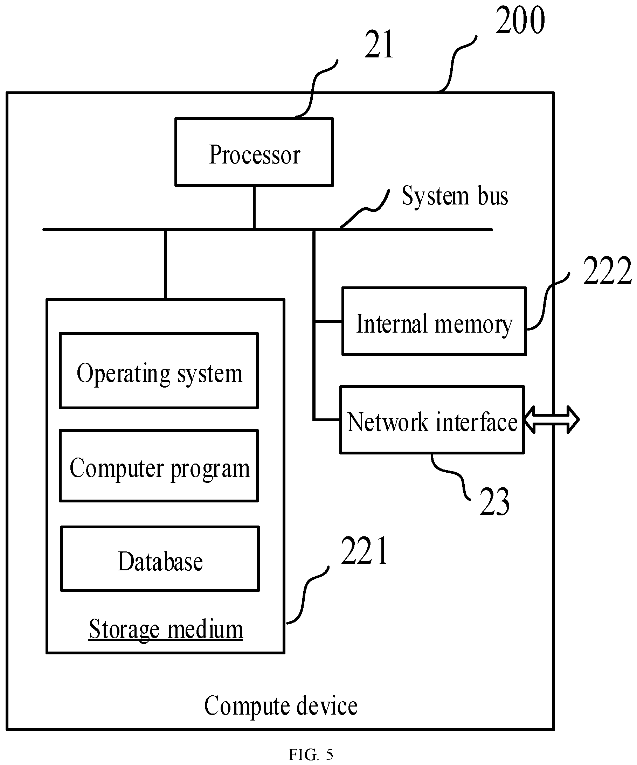

The present invention further provides a computer device 200. The computer device may be a server. FIG. 5 is an internal structural diagram of a computer device in an embodiment of the present invention. Referring to FIG. 5, the computer device includes a processor 21, a memory, and a network interface 23 which are connected by a system bus. The processor 21 of the computer device is configured to provide a computing and control capability. The storage of the computer device includes a storage medium 221 and an internal storage 222. The storage medium 221 stores an operating system, a computer program, and a database. The internal storage 222 provides an environment for operation of an operating system and a computer program in the storage medium 221. The database of the computer device is configured to store a detection signal. The network interface 23 of the computer device is configured to be in communication with an external terminal by a network connection. The computer program is executed by the processor 21 to implement the access method of the parallel branch in the battery system.

One skilled in the art may understand that the structure shown in FIG. 5 is merely a block diagram of some structures related to the solutions of the present invention, and does not constitute a limitation on a computer device to which the solutions of the present invention are applied. A specific computer device may include more or fewer components than those shown in the figure, or combine some components, or have different component arrangements.

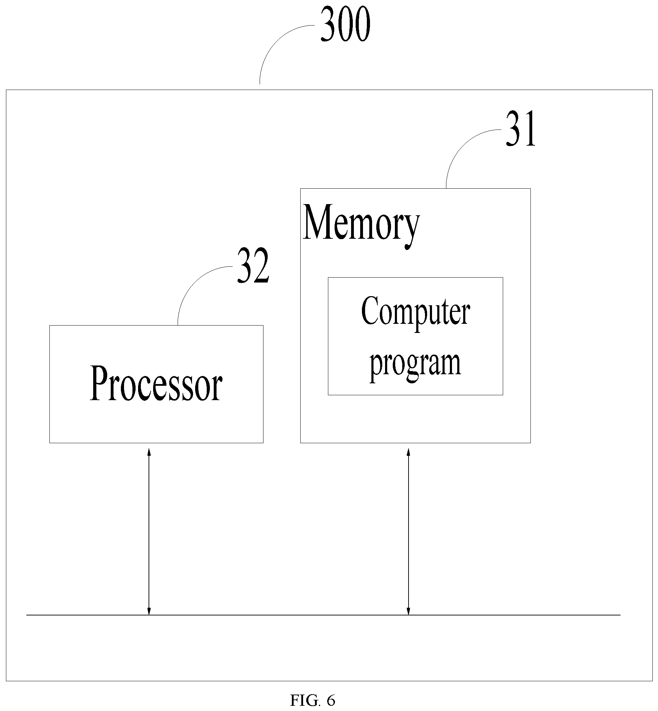

Referring to FIG. 6, the present invention further provides an electronic device 300, including a memory 31 and a processor 32. The memory 31 stores a computer program, and the processor 32 is configured to execute the computer program to perform the steps in any one of the above method embodiments.

Alternatively, the electronic device may further include a transmission device and an input/output device. The transmission device is connected to the processor 32, and the input/output device is connected to the processor 32.

Alternatively, in the present embodiment, the processor 32 is configured to perform following steps by a computer program:
Step 1 includes detecting a to-be-accessed branch of a battery.
Step 2 includes that when the detection succeeds, acquiring a voltage difference between an accessed branch of a battery system and the to-be-accessed branch, and when the voltage difference satisfies a first preset range, accessing the to-be-accessed branch to the battery system.

It should be noted that for a specific example in the present embodiment, reference may be made to the example described in the foregoing embodiments and alternative implementation, and details are not described herein again in the present embodiment.

In addition, with reference to the access method of the parallel branch in the battery system in the foregoing embodiment, a storage medium 321 is provided in an embodiment of the present invention. The storage medium 321 stores a computer program. When the computer program is executed by the processor, any one of the access methods of the parallel branch in the battery system in the foregoing embodiments is implemented.

One skilled in the art may understand that all or a part of the processes in the methods in the foregoing embodiments may be implemented by a computer program instructing related hardware. The computer program may be stored in a non-transitory computer readable storage medium. When the computer program is executed, the processes in the foregoing method embodiments may be included. Any reference to a memory, a storage, a database, or other mediums used in the embodiments provided in the present invention may include a non-transitory and/or transitory memory. The non-transitory memory may include a read-only memory (ROM), a programmable ROM (PROM), an electrically programmable ROM (EPROM), an electrically erasable programmable ROM (EEPROM), or a flash memory. The transitory memory may include a random-access memory (RAM) or an external cache memory. As an illustration and not a limitation, the RAM may be obtained in a plurality of forms, such as static RAM (SRAM), dynamic RAM (DRAM), synchronous DRAM (SDRAM), dual data rate SDRAM (DDRSDRAM), enhanced SDRAM (ESDRAM), synchronous link (Synch link) DRAM (SLDRAM), memory bus (Rambus) direct RAM (RDRAM), direct memory bus dynamic RAM (DRDRAM), and memory bus dynamic RAM (RDRAM).

The various technical features of the above-described embodiments may be combined arbitrarily, and all possible combinations of the various technical features of the above-described embodiments have not been described for the sake of conciseness of description. However, as long as there is no contradiction in the combinations of these technical features, they should be considered to be within the scope of the present description.

The above-described embodiments express only several embodiments of the present invention, which are described in a more specific and detailed manner, but are not to be construed as a limitation on the scope of the present invention. For one skilled in the art, several deformations and improvements can be made without departing from the conception of the present invention, all of which fall within the scope of protection of the present invention. Therefore, the scope of protection of the present invention shall be subject to the attached claims.

## Claims

1. An access method of a parallel branch in a battery system, **characterized by** comprising:
detecting a to-be-accessed branch of a battery; and
when the detection succeeds, acquiring a voltage difference between an accessed branch of the battery system and the to-be-accessed branch, and when the voltage difference satisfies a first preset range, accessing the to-be-accessed branch to the battery system.

2. The method of claim 1, wherein conditions for the detection to succeed comprise: data of the to-be-accessed branch is in a readable state, the to-be-accessed branch is not in an alarm or error state, and a maximum branch current value of the accessed branch of the battery system is less than or equal to a first preset value.

3. The method of claim 2, wherein before acquiring the voltage difference between the accessed branch of the battery system and the to-be-accessed branch, the method further comprises:
changing a system current request and a connection status signal, wherein the connection status signal represents a connection status between the to-be-accessed branch and the accessed branch of the battery system.

4. The method of claim 3, wherein changing the system current request and the connection status signal further comprises:
defining the system current request as: a second preset value * the quantity of the accessed branch of the battery system; and
when the voltage difference satisfies the first preset range, accessing the to-be-accessed branch to the battery system further comprises:
when the voltage difference satisfies the first preset range, a current value of the accessed branch of the battery system satisfies a second preset range, and a duration period satisfying foregoing two conditions is greater than or equal to a first preset time, accessing the to-be-accessed branch to the battery system.

5. The method of claim 4, wherein changing the system current request and the connection status signal further comprises:
acquiring an initial voltage difference between the accessed branch of the battery system and the to-be-accessed branch, and an initial current value of the accessed branch of the battery system, and when the initial voltage difference and the initial current value satisfy a preset condition, performing the step of changing the system current request and the connection status signal.

6. The method of claim 5, further comprising:
within a second preset time, when the voltage difference does not satisfy the first preset range, the current value of the accessed branch of the battery system does not satisfy the second preset range, or a duration period satisfying either of the foregoing two conditions is shorter than the first preset time, returning to the step of acquiring the initial voltage difference between the accessed branch of the battery system and the to-be-accessed branch, and the initial current value of the accessed branch of the battery system.

7. The method of claim 1, further comprising:
when the battery has a plurality of to-be-accessed branches which are at a same voltage level, accessing the plurality of to-be-accessed branches to the battery system simultaneously.

8. The method of claim 1, further comprising:
after accessing the to-be-accessed branch to the battery system, updating a limiting current of the battery system according to the quantity of accessed branches.

9. The method of claim 1, wherein conditions for the detection to succeed comprise: data of the to-be-accessed branch is in a readable state, and the to-be-accessed branch is not in an alarm or error state.

10. The method of claim 9, wherein when the voltage difference satisfies the first preset range, accessing the to-be-accessed branch to the battery system further comprises:
acquiring an average current value of accessed branches according to an actual operating current of the battery and the quantity of the accessed branches; and
when the voltage difference satisfies the first preset range, the average current value satisfies a second preset range, and a duration period satisfying foregoing two conditions is in a third preset time range, accessing the to-be-accessed branch to the battery system.

11. The method of claim 10, wherein accessing the to-be-accessed branch to the battery system further comprises:
after the voltage difference satisfies the first preset range, the average current value satisfies the second preset range, and the duration period satisfying foregoing two conditions is in the third preset time range, when a duration period in which the average current value satisfies a third preset range reaches a fourth preset time, accessing the to-be-accessed branch to the battery system in a fifth preset time.

12. The method of claim 10, further comprising:
when the duration period in which the average current value satisfies a third preset range does not reach a fourth preset time, aborting the step of accessing the to-be-accessed branch to the battery system, and returning to the step of acquiring the voltage difference between the accessed branch of the battery system and the to-be-accessed branch.

13. A battery management system, **characterized in that** the battery management system is configured to execute the method of any one of claims 1 to 12.

14. A electronic device, **characterized by** comprising a memory and a processor, wherein a computer program is stored in the memory, and the processor is configured to execute the computer program to perform the method of any one of claims 1 to 12.

15. A storage medium, **characterized by** storing a computer program, wherein the computer program is executed by a processor to perform the method of any one of claims 1 to 12.
